# EUROPEAN PATENT APPLICATION

(11) **EP 1 439 744 A2**
(43) Date of publication of application: **21.07.2004**
(21) Application number: 04250191.6
(22) Date of filing: 15.01.2004
(51) Int. Cl.: H05K 3/34

(54) **Apparatus and method for aligning and attaching solder columns to a substrate**

(30) Priority: 15.01.2003 JP 2003006464; 20.01.2003 JP 2003010817
(71) Applicant: SENJU METAL INDUSTRY CO., LTD., Tokyo (JP)
(72) Inventor: Nomoto, Shinichi Senju Metal Industry Co., Ltd., Adachi-ku Tokyo (JP); Nauchi, Takashi Senju Metal Industry Co., Ltd., Adachi-ku Tokyo (JP)
(74) Representative: Makovski, Priscilla Mary

(57) **Abstract**

An apparatus and method for aligning and attaching a plurality of solder columns (26) to a patterned array of corresponding electrical contacts (24) on a ceramic substrate (22). The apparatus includes an alignment plate (12) in which a plurality of through holes (14) are defined in a pattern identical to the pattern of the electrical contacts (24). Four retainers (18) hold the alignment plate (12) in a fixed position above the substrate (22) such that the through holes (14) are vertically aligned with the corresponding electrical contacts (24). The solder columns (26) are inserted through the through holes (14) so that the solder columns (26) are placed in an upright position on the respective electrical contacts (24). A low melting solder paste (28) is applied onto the electrical contacts (24). The alignment plate (12) and the substrate (22) are heated so that the solder paste (28) is reflowed and wetted onto the solder columns (26) and the electrical contacts (24). The solder paste (28) is thereafter resolidified.

## Description

The present invention relates an apparatus and method for aligning, placing and attaching a plurality of solder columns to a patterned array of electrical terminals or conductive pads on a ceramic substrate.

As the density of electronic devices on integrated circuits has continued to increase, the number of leads required for a chip has also increased. To handle the increased density, there has been developed a ball grid array package wherein one or more chips are mounted on the top surface of a substrate. The ball grid array package uses an array of solder balls to provide electrical connections between the substrate and a printed circuit board. A problem with this type of package is that substantial differences in the thermal coefficient of expansion can exist between the substrate and the printed circuit board. Such differences in the thermal coefficient of expansion cause plastic deformation of the solder balls.

This problem is alleviated by means of a ceramic column grid array package. The column grid array package uses an array of solder columns to make electrical connections between a ceramic substrate and a printed circuit board. The solder columns typically have a height of approximately 2.55 mm and a diameter of 0.50 mm. The taller configuration of the solder columns offers compliancy to better absorb the differential thermal expansion rate between the ceramic column grid array package and the printed circuit board. To attach the solder columns to the substrate, a low melting temperature solder paste is deposited on electrically conductive contact pads which are placed on one side of the ceramic substrate. The solder columns, typically made from a high melting temperature solder using a nominal 90/10 alloy of lead to tin, are vertically positioned on the corresponding contact pads. The combination is then heated in a reflow oven so that the solder paste is reflowed to make a mechanical and electrical connection between the solder columns and the pads.

In the manufacture of a ball grid array package, a vacuum pickup tool is typically used to pick up and place a multiplicity of solder balls in the desired pattern on a semiconductor substrate. The spherical shape of the solder balls makes it easier to pick up and place a full array of solder balls on the substrate. On the other hand, solder columns have a cylindrical shape and must, therefore, be placed in an upright orientation when the solder columns are attached to corresponding conductive pads on a ceramic substrate.

Accordingly, it is an object of the present invention to provide an apparatus and method for aligning and attaching an array of solder columns to a substrate, which enable the solder columns to be readily and simultaneously placed in an upright position on corresponding conductive pads on the substrate.

According to one aspect of the present invention, there is provided an apparatus for aligning and attaching a plurality of solder columns to a patterned array of corresponding electrical contacts on a ceramic substrate. The apparatus includes a substantially flat alignment plate having a plurality of through holes defined in a pattern identical to the pattern of the electrical contacts and adapted to allow the solder columns to vertically pass therethrough. At least one retainer depends from the alignment plate and adapted to hold the alignment plate in a fixed position above the ceramic substrate such that the through holes are vertically aligned with the corresponding electrical contacts. In one embodiment, four retainers are attached to the respective four sides of the rectangular alignment plate. The alignment plate is preferably made of a refractory material such as titanium.

A vacuum pickup tool may be used to deliver an array of solder columns to the alignment plate. In one embodiment, the vacuum pickup tool includes a vacuum head and a carrier projection extending from the bottom of the vacuum head. A series of cavities are defined in the carrier projection and each have vacuum ports communicated with a vacuum source. The cavities are spaced from each other a distance equal to the distance between each adjacent through holes of the alignment plate.

According to another aspect of the present invention, there is provided a method for aligning and attaching a plurality of solder columns to a patterned array of corresponding electrical contacts on a substrate. The method includes the step of providing a substantially flat alignment plate including a plurality of through holes defined in a pattern identical to the pattern of the electrical contacts. A solder paste is screen printed or otherwise applied onto the electrical contacts. The alignment plate is held in a fixed position above the substrate such that the through holes are vertically aligned with the electrical pads. The solder columns are inserted through the through holes of the alignment plate. This allows the solder columns to be placed in an upright orientation on the electrical contacts. The alignment plate and the substrate are passed through a reflow oven so as to reflow or melt the solder paste. The solder paste is thereafter resolidified to make a bond between the solder columns and the corresponding electrical contacts. The alignment plate is removed from the substrate after the solder columns are attached to all the electrical contacts on the ceramic substrate.

The above and other objects, features and advantages of the present invention will become apparent from the following detailed description of the preferred embodiments of the invention.
Fig. 1 is a perspective view of an apparatus for aligning and attaching solder columns to a substrate before it is mounted thereto;
Figs. 2 to 6 sequentially illustrate a method for aligning and attaching an array of solder columns to an array of corresponding electrically conductive pads on the ceramic substrate;
Fig. 7 is a perspective view of a vacuum pickup tool configured to capture an array of solder columns sequentially supplied by a solder column dispenser;
Figs. 8 to 10 sequentially illustrate the manner in which an array of solder columns are held into a series of respective cavities by vacuum; and
Fig. 11 is a perspective view of the vacuum pickup tool in which the solder columns are held in a horizontal orientation.

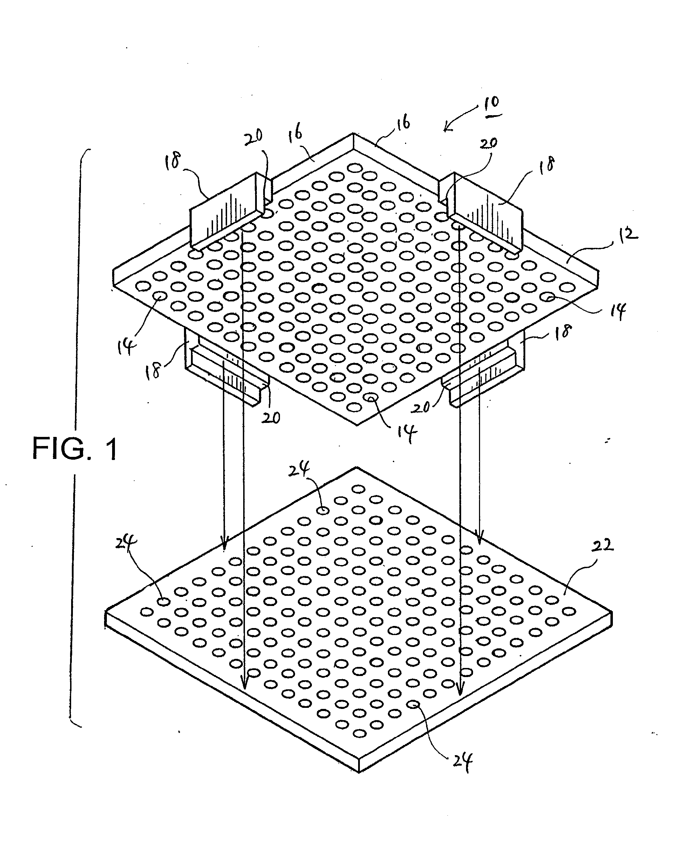

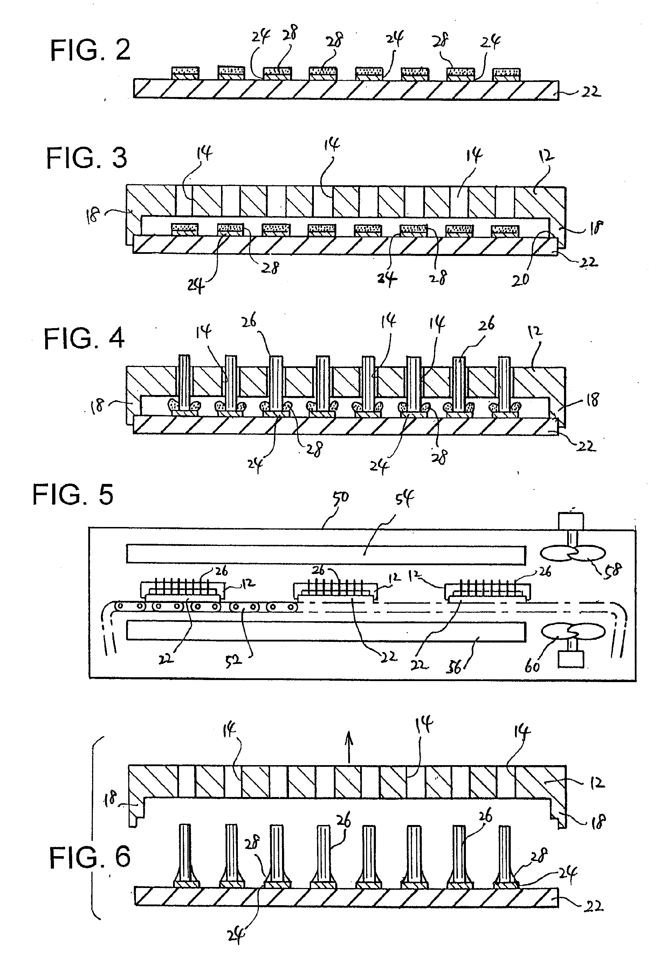

Referring first to Fig. 1, there is illustrated an apparatus, generally designated at 10, for aligning and attaching an array of solder columns to a substrate. The apparatus 10 includes a substantially flat alignment plate 12 in which a plurality of through holes 14 are defined in a patterned array. The alignment plate 12 is square or rectangular in shape and has four sides 16. The alignment plate 12 has a thickness of at least 0. 5 mm. The alignment plate 12 is preferably made of titanium to provide better resistance to heat. Alternatively, the alignment plate 12 may be made of any other suitable refractory materials such as titanium alloy, ceramic, stainless steel, engineering plastics, carbon, carbide and nitride. In the illustrated embodiment, four retainers 18 depend from intermediate the four respective sides 16 of the alignment plate 12. The retainers 18 each have a step 20. The steps 20 are sized and configured to engage the upper peripheral edge of a substrate 22, as shown better in Figs. 3 and 4. Although not shown, four angled retainers may alternatively be attached to the four corners of the alignment plate 12. The alignment plate 12 has a size substantially equal to the size of the substrate. The substrate 22 is typically made of ceramic. The ceramic substrate 22 has a plurality of electrically conductive pads or contacts 24 arranged in a pattern identical to the pattern of the through holes 14 of the alignment plate 12. The number of the through holes 14 is equal to the number of the conductive pads 24.

Figs 2 to 6 sequentially illustrate the manner in which an array of solder columns 26 are attached to the conductive pads 24 on the ceramic substrate 22. Referring specifically to Fig. 2, a solder paste 28 is screen printed onto all the conductive pads 24. The alignment plate 12 is then mounted over the ceramic substrate 22 as shown in Fig. 3. The retainers 18 hold the alignment plate 12 in a fixed position above the ceramic substrate 22. The alignment plate 12 is vertically spaced a distance away from the ceramic substrate 22 such that they are held out of contact with the solder paste 28. The retainers 18 thus serve as both positioners and spacers. With the alignment plate 12 mounted over the ceramic substrate 22, the through holes 14 are vertically aligned with the respective conductive pads 24.

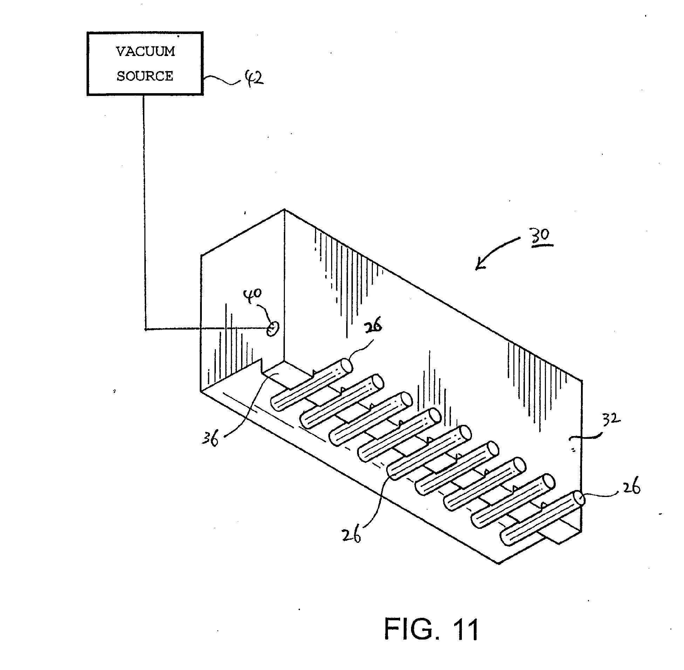

As shown in Fig. 7, a vacuum pickup tool, generally designated at 30, is used to deliver an array of solder columns to the alignment plate 12. In the illustrated embodiment, the vacuum pickup tool 30 includes a vacuum block or head 32 moved between a solder column dispenser 34 and the alignment plate 12 by suitable drive means (not shown). A carrier projection 36 projects downwardly from the bottom of the vacuum head 32 adjacent to its front end and extends between opposite lateral sides of the vacuum head 32. It is preferred that the width or depth of the carrier projection 36 be substantially less than the length of the solder columns 26, as shown better in Fig. 11. A series of rectangular cavities 38 are defined in the carrier projection 36. The cavities 38 may alternatively have a semicircular or any other suitable cross section. The cavities 38 have a width slightly greater than the diameter of the solder columns 26. The cavities 38 have a depth substantially equal to half the diameter of the solder columns 26. The distance between each adjacent cavities 38 is equal to the distance between each adjacent through holes 14 of the alignment plate 12. The vacuum head 32 has an internal vacuum channel 40 connected to a vacuum source 42 (Fig. 11). A series of vacuum ports 44 are defined in the carrier projection 36 and communicated with the common vacuum channel 40.

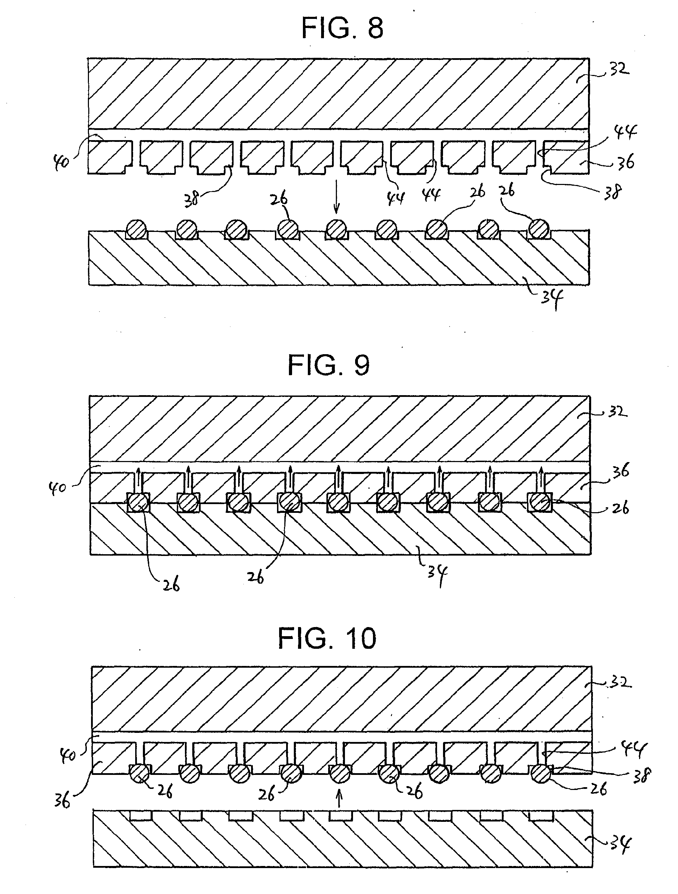

Referring to Fig. 8, the vacuum pickup tool 30 is moved over the downstream end of the solder column dispenser 34 so that the cavities 38 are aligned with the respective solder columns 26. As shown in Fig. 9, the vacuum pickup tool 30 is lowered until the bottom of the carrier projection 36 is brought into contact with the upper surface of the solder column dispenser 34. A vacuum is then pulled through the vacuum channel 40 and the vacuum ports 44 in order to draw the solder columns 26 into the respective cavities 38 of the vacuum pickup tool 30. Thereafter, the vacuum pickup tool 30 is lifted up from the solder column dispenser 34 as shown in Fig. 10. At this time, the solder columns 26 are held in a horizontal orientation as shown in Fig. 11.

With the solder columns 26 held into the cavities 38, the vacuum pickup tool 30 is moved over the alignment plate 12. Although not shown, the vacuum pickup tool 30 is rotated 90 degrees to move the solder columns 26 into a vertical orientation. Referring back to Fig. 4, with the solder columns 26 axially aligned with the respective through holes 14, the vacuum is released to cause the solder columns 26 to fall into the through holes 14. To this end, the through holes 14 have a diameter slightly greater than the diameter of the solder columns 26. The solder columns 26 are finally placed on the respective conductive pads 24.

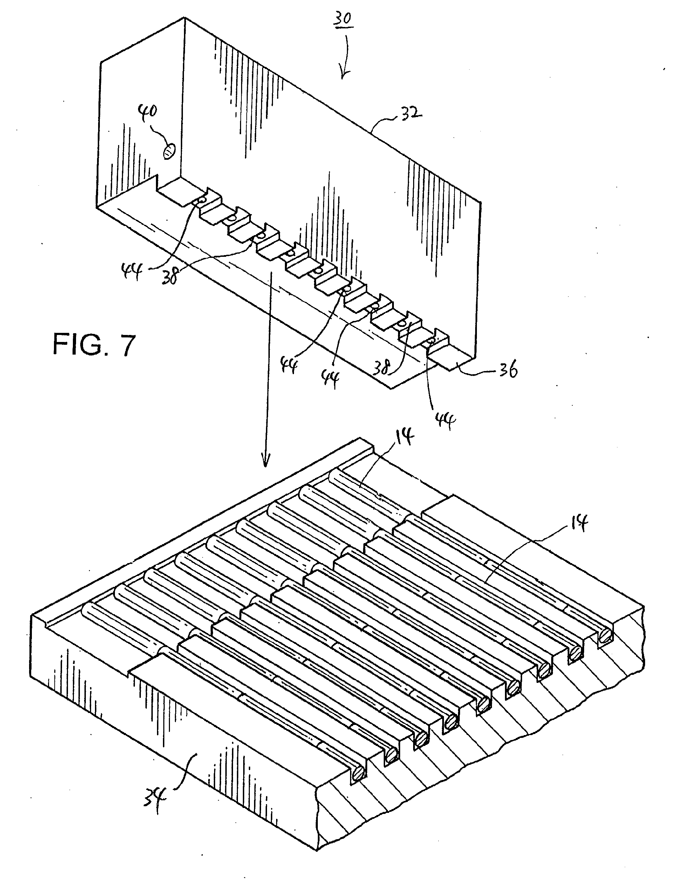

As shown in Fig. 5, the alignment plate 12 and the ceramic substrate 22 are passed through a reflow oven 50 by means of a conveyor 52. At this time, the retainers prevents relative movement between the alignment plate 12 and the ceramic substrate 22. Upper and lower heaters 54, 56 are arranged above and below the conveyor 52 in order to apply sufficient heat to the alignment plate 12 and the ceramic substrate 22. This causes the low melting solder paste 28 to melt. As a result, the solder paste 28 is wetted onto the solder columns 26 and the conductive pads 24. Upper and lower fans 58, 60 are provided within the reflow oven 50 downstream of the heaters 54, 56 in order to resolidify the material of the solder paste 28 to form a metallurgical bond between the solder columns 26 and the respective pads 24. As shown in Fig. 6, after the alignment plate 12 and the ceramic substrate 22 are delivered out of the reflow oven 50, the alignment plate 12 is removed from the ceramic substrate 22. This process is repeated until the solder columns 26 are attached to all the conductive pads 24 to form a ceramic column grid array package.

Although the present invention has been described with respect to its preferred embodiment, it is to be understood that various modifications and changes may be made without departing from the scope of the invention as defined by the appended claims.

## Claims

1. An apparatus for aligning and attaching a plurality of solder columns (26) to a patterned array of corresponding electrical contacts (24) on a substrate (22), said apparatus comprising:
a substantially flat alignment plate (12) having a plurality of through holes (14) defined in a pattern identical to the pattern of the electrical contacts (24) and adapted to allow the solder columns (26) to vertically pass therethrough; and
at least one retainer (18) depending from said alignment plate (12) and adapted to hold said alignment plate (12) in a fixed position above the substrate (22) such that said through holes (14) are vertically aligned with the corresponding electrical contacts (24).

2. The apparatus of claim 1, wherein the substrate (22) has a peripheral edge, and said at least one retainer (18) includes a step (20) sized and configured to engage the peripheral edge of the substrate (22).

3. The apparatus of claim 1, wherein said alignment plate (12) is substantially rectangular in shape and has four sides (16), further comprising four retainers (18) depending from the respective four sides (16) of said alignment plate (12).

4. The apparatus of any one of claims 1 to 3, wherein said alignment plate (12) is made of a refractory material selected from the group consisting of titanium, titanium alloy, ceramic, stainless steel, engineering plastics, carbon, carbide and nitride.

5. The apparatus of any one of claims 1 to 4, wherein said alignment plate (12) has a thickness of at least 0.5 mm.

6. The apparatus of any one of claims 1 to 5, further comprising a vacuum pickup tool (30) operatively associated with said alignment plate (12) and adapted to deliver solder columns to the alignment plate (12), said vacuum pickup tool (30) comprising a vacuum head (32) having a bottom, a carrier projection (36) extending from the bottom of said vacuum head (32), and a series of cavities (38) defined in said carrier projection (36) and each having vacuum ports (44) communicated with a vacuum source (42), said cavities (38) being spaced from each other a distance equal to the distance between each adjacent through holes (14) of said alignment plate (12).

7. A method for aligning and attaching a plurality of solder columns (26) to a patterned array of corresponding electrical contacts (24) on a substrate (22), said method comprising:
providing a substantially flat alignment plate (12) including a plurality of through holes (14) defined in a pattern identical to the pattern of the electrical contacts (24);
applying a solder paste (28) onto the electrical contacts (24);
holding the alignment plate (12) in a fixed position above the substrate (22) such that the through holes (14) are vertically aligned with the electrical contacts (24);
passing the solder columns (26) through the through holes (14) of the alignment plate (12) so as to place the solder columns (26) in an upright orientation on the electrical contacts (24);
melting the solder paste (28);
resolidifying the solder paste (28) to make a bond between the solder columns (26) and the corresponding electrical contacts (24); and
removing the alignment plate (12) from the substrate (22) after the solder columns (26) are attached to all of said electrical contacts (24).
